# EUROPEAN PATENT APPLICATION

(11) **EP 4 832 346 A1**
(43) Date of publication of application: **28.10.2026**
(21) Application number: 24910587.5
(22) Date of filing: 04.12.2024
(51) Int. Cl.: H03H 9/17

(54) **ACOUSTIC RESONATOR, FILTER AND ELECTRONIC DEVICE**

(30) Priority: 27.12.2023 CN 202311834252
(71) Applicant: Huawei Technologies Co., Ltd., Shenzhen, Guangdong 518129 (CN)
(72) Inventor: BAO, Jingfu, Chengdu, Sichuan 611731 (CN); LIU, Yiming, Chengdu, Sichuan 611731 (CN); LI, Yawei, Shenzhen, Guangdong 518129 (CN); HUANG, Yulin, Shenzhen, Guangdong 518129 (CN); HOU, Hangtian, Shenzhen, Guangdong 518129 (CN)
(74) Representative: Maiwald GmbH
(86) International application number: PCT/CN2024/136722
(87) International publication number: WO 2025/139655

(57) **Abstract**

This application provides an acoustic resonator, a filter, and an electronic device. The acoustic resonator includes a substrate layer, a piezoelectric transducer structure layer, and an energy adjustment layer. The piezoelectric transducer structure layer is disposed on one side of the substrate layer. The energy adjustment layer is disposed between the substrate layer and the piezoelectric transducer structure layer, where the energy adjustment layer includes a plurality of confinement grooves, and each confinement groove passes through at least a surface that is of the energy adjustment layer and that faces the piezoelectric transducer structure layer. In this application, acoustic wave energy is concentrated on the piezoelectric transducer structure layer through the spaced-apart confinement grooves that pass through the surface that is of the energy adjustment layer and that faces the piezoelectric transducer structure layer, so that leakage of the acoustic wave energy toward the substrate layer is reduced. This helps improve an electromechanical coupling coefficient of the acoustic resonator. In addition, the piezoelectric transducer structure layer is supported through parts that are of the energy adjustment layer and that are between adjacent confinement grooves, so that collapse of the piezoelectric transducer structure layer is avoided, and a risk of reducing the power capacity of the acoustic resonator is lowered. This improves the power capacity and electromechanical coupling coefficient of the acoustic resonator.

## Description

This application claims priority to Chinese Patent Application No. 202311834252.X, filed with the China National Intellectual Property Administration on December 27, 2023 and entitled "ACOUSTIC RESONATOR, FILTER, AND ELECTRONIC DEVICE", which is incorporated herein by reference in its entirety.

### TECHNICAL FIELD

This application relates to the field of semiconductor technologies, and in particular, to an acoustic resonator, a filter, and an electronic device.

### BACKGROUND

With development of communication technologies, to achieve real-time high-speed transmission of massive data in a communication network, a channel bandwidth needs to be increased in the high-speed communication network. Usually, a large-bandwidth filter is used in the high-speed communication network to increase the channel bandwidth. A resonator used as a design unit of the filter is a main component for increasing the bandwidth of the filter.

Both the power capacity and electromechanical coupling coefficient of the resonator affect the bandwidth design of the filter. Therefore, how to improve the power capacity and electromechanical coupling coefficient of the resonator to increase the channel bandwidth of the filter is currently a focus and a difficulty in research on resonators.

### SUMMARY

This application provides an acoustic resonator, a filter, and an electronic device, to improve the power capacity and electromechanical coupling coefficient of a resonator, thereby improving communication performance of the filter.

According to a first aspect, an acoustic resonator is provided. The acoustic resonator includes a substrate layer, a piezoelectric transducer structure layer, and an energy adjustment layer. The piezoelectric transducer structure layer is disposed on one side of the substrate layer. The energy adjustment layer is disposed between the substrate layer and the piezoelectric transducer structure layer, where the energy adjustment layer includes a plurality of confinement grooves, and each confinement groove passes through at least a surface that is of the energy adjustment layer and that faces the piezoelectric transducer structure layer.

According to the acoustic resonator provided in this application, the energy adjustment layer is located on a side that is of the piezoelectric transducer structure layer and that faces away from an electrode layer, and the confinement grooves pass through the surface that is of the energy adjustment layer and that faces the piezoelectric transducer structure layer. Therefore, in a propagation process of acoustic wave energy, the energy may be concentrated on the piezoelectric transducer structure layer through the plurality of confinement grooves of the energy adjustment layer, so that leakage of the acoustic wave energy toward the substrate layer is reduced. This helps improve an electromechanical coupling coefficient of the acoustic resonator. In addition, the piezoelectric transducer structure layer is supported through parts that are of the energy adjustment layer and that are between adjacent confinement grooves, so that collapse of the piezoelectric transducer structure layer is avoided, and a risk of reducing the power capacity of the acoustic resonator is lowered. This ensures the power capacity of the acoustic resonator, and improves performance of the acoustic resonator. Therefore, the power capacity and the electromechanical coupling coefficient of the acoustic resonator are improved, thereby helping improve performance of a filter.

In some embodiments, each confinement groove further passes through a surface that is of the energy adjustment layer and that faces away from the piezoelectric transducer structure layer. In this way, the confinement grooves pass through the surface that is of the energy adjustment layer and that faces away from the piezoelectric transducer structure layer, so that the acoustic wave energy enters the confinement grooves and is concentrated on one side of the piezoelectric transducer structure layer.

In some embodiments, the piezoelectric transducer structure layer includes a piezoelectric material layer and an interdigital transducer structure located on a side that is of the piezoelectric material layer and that faces away from the substrate layer, the interdigital transducer structure includes a plurality of first interdigital electrodes and a plurality of second interdigital electrodes that are disposed in an interdigitated manner and opposite to each other along a first direction, and the first direction is parallel to the substrate layer; and the confinement groove extends from one of two opposite sides of the energy adjustment layer in a second direction to the other side, the second direction is parallel to the substrate layer, and the second direction is parallel to or perpendicular to the first direction.

In this way, the first interdigital electrodes and the second interdigital electrodes are disposed in an interdigitated manner, so that the acoustic wave energy is reflected back and forth in the piezoelectric material layer to form oscillation, thereby achieving a transduction function of the acoustic resonator. In addition, in the interdigitated manner, the first interdigital electrodes and the second interdigital electrodes achieve a higher distribution ratio on the piezoelectric material layer, so that an area occupied by the first interdigital electrodes and the second interdigital electrodes is reduced. Therefore, the first interdigital electrodes and the second interdigital electrodes are distributed more compactly, so that a size of the acoustic resonator is reduced.

In some embodiments, an extension direction of each confinement groove is parallel to the second direction, or forms an acute angle of less than 60° with the second direction. In this way, when the confinement grooves are formed through processing on the energy adjustment layer, the second direction is used as a reference direction to form, through processing, confinement grooves extending along a same direction, so that confinement grooves that are arranged neatly are formed through processing.

In some embodiments, the confinement groove is wavy, and a line connecting two ends of the confinement groove extends along the second direction. In this way, the wave-shaped confinement grooves can be used to increase space occupied by the confinement grooves on the energy adjustment layer, thereby increasing space for concentrating the acoustic wave energy on the piezoelectric material layer through the confinement grooves, and enhancing a capability of concentrating the acoustic wave energy through the confinement grooves.

In some embodiments, a part of the confinement grooves extends along the second direction, the other part of the confinement grooves extends along a third direction, and the second direction is not parallel to the third direction. In this way, an extension direction of a part of the confinement grooves is different from an extension direction of the other part of the confinement grooves, so that processing on the energy adjustment layer is performed along the two different directions. This facilitates adjustment of a processing direction of the energy adjustment layer, thereby improving convenience of processing the confinement grooves.

In some embodiments, the plurality of confinement grooves include a plurality of first grooves and a plurality of second grooves, the first groove extends from one of two opposite sides of the energy adjustment layer in the second direction to the other side, the second groove extends from one of two opposite sides of the energy adjustment layer in a third direction to the other side, and the third direction is not parallel to the second direction. In this way, the plurality of first grooves and the plurality of second grooves extend along different directions, and the plurality of first grooves and the plurality of second grooves are disposed in an interdigitated manner, so that a distribution ratio of the confinement grooves on the energy adjustment layer is increased. This increases a proportion of the confinement grooves on the energy adjustment layer, thereby helping improve an effect of concentrating the acoustic wave energy through the confinement grooves.

In some embodiments, a Bragg reflection layer is further included, where the Bragg reflection layer is located between the substrate layer and the energy adjustment layer. In this way, the acoustic wave energy is better reflected to the piezoelectric material layer through the Bragg reflection layer, so that the acoustic wave energy is concentrated on the piezoelectric material layer through the confinement grooves of the energy adjustment layer. This further improves the electromechanical coupling coefficient of the acoustic resonator.

In some embodiments, the energy adjustment layer further includes dividing parts, the dividing parts divide the energy adjustment layer into the plurality of confinement grooves, and the dividing parts occupy a range of 1% to 99% of an area of the energy adjustment layer. In this way, the piezoelectric transducer structure layer is supported through the dividing parts, so that the collapse of the piezoelectric transducer structure layer is avoided, and the risk of reducing the power capacity of the acoustic resonator is lowered. This ensures the power capacity of the acoustic resonator.

In some embodiments, a material of the energy adjustment layer includes at least one of SiO₂, SiOC, Si₃N₄, AlN, Pt, Mo, W, and HfO₂. In this way, a support body has a high reflection coefficient, thereby improving an effect of limiting the acoustic wave energy by an engineering material layer.

According to a second aspect, a preparation method for an acoustic resonator is provided. The preparation method includes: providing a substrate layer, and forming a piezoelectric transducer structure layer on one side of the substrate layer; and forming an energy adjustment layer between the substrate layer and the piezoelectric transducer structure layer, where the energy adjustment layer includes a plurality of confinement grooves, and each confinement groove passes through at least a surface that is of the energy adjustment layer and that faces the piezoelectric transducer structure layer.

The acoustic resonator formed based on the preparation method for the acoustic resonator provided in this embodiment of this application includes the foregoing acoustic resonator, and therefore has all beneficial effects of the foregoing acoustic resonator. Details are not described herein again.

According to a third aspect, a filter is provided. The filter includes a plurality of cascaded resonators, where at least one of the plurality of cascaded resonators is the acoustic resonator in any one of the foregoing embodiments.

In the filter provided in this embodiment, the acoustic resonator in any one of the foregoing embodiments may be used, so that the filter can achieve a large channel bandwidth by using features of a high electromechanical coupling coefficient and a high power capacity of the acoustic resonator.

According to a fourth aspect, an electronic device is provided. The electronic device includes a filter and a circuit board, where the filter is disposed on the circuit board, and the filter is the filter according to the second aspect. Because the electronic device has the same technical effect as the acoustic resonator provided in the first aspect, for details, refer to related descriptions of the first aspect. Details are not described herein again.

### BRIEF DESCRIPTION OF DRAWINGS

FIG. 1 is a block diagram of a structure of an electronic device according to an embodiment;
FIG. 2 is a cross-sectional diagram of a laterally-excited bulk acoustic wave resonator according to an embodiment;
FIG. 3 is an admittance curve diagram of a laterally-excited bulk acoustic wave resonator according to an embodiment;
FIG. 4 is a diagram of a three-dimensional structure of an acoustic resonator according to an embodiment of this application;
FIG. 5 is a cross-sectional diagram of an acoustic resonator in an X-Z direction according to an embodiment;
FIG. 6 is a diagram of a three-dimensional structure of an acoustic resonator according to an embodiment of this application when a first direction is parallel to a second direction;
FIG. 7 is a cross-sectional diagram of an acoustic resonator in an X-Z direction according to an embodiment;
FIG. 8 is a cross-sectional diagram of confinement grooves whose cross-sectional shapes are straight strips in an X-Y direction according to an embodiment;
FIG. 9 is a cross-sectional diagram of confinement grooves whose cross-sectional shapes are wavy in an X-Y direction according to an embodiment;
FIG. 10 is a diagram of a three-dimensional structure of an acoustic resonator according to an embodiment when there is no Bragg reflection layer and a second direction is perpendicular to a first direction;
FIG. 11 is a diagram of a three-dimensional structure of an acoustic resonator according to an embodiment when there is no Bragg reflection layer and a second direction is parallel to a first direction;
FIG. 12 is a diagram of a three-dimensional structure of an acoustic resonator according to an embodiment when confinement grooves are formed through etching along a second direction and a third direction;
FIG. 13 is a cross-sectional diagram of confinement grooves according to an embodiment when a second direction is perpendicular to a third direction;
FIG. 14 is a cross-sectional diagram of dividing parts whose cross-sectional shapes are circular on an X-Y plane according to an embodiment;
FIG. 15 is a curve diagram of a relationship between a frequency and a quality factor Q of an acoustic resonator according to an embodiment;
FIG. 16 is a curve diagram of an electromechanical coupling coefficient of an acoustic resonator etched along an X direction and a Y direction according to an embodiment;
FIG. 17 is a slowness curve diagram of an acoustic resonator in an X-Y direction according to an embodiment;
FIG. 18 is a comparison diagram of dispersion curves of an acoustic resonator according to an embodiment; and
FIG. 19 is a flowchart of a preparation method for an acoustic resonator according to an embodiment.

### DESCRIPTION OF EMBODIMENTS

To make a person skilled in the art better understand solutions in the present invention, the following clearly and completely describes the technical solutions in embodiments of the present invention with reference to accompanying drawings in embodiments of the present invention. It is clear that the described embodiments are merely some rather than all of embodiments of the present invention. All other embodiments obtained by a person of ordinary skill in the art based on embodiments of the present invention without creative efforts shall fall within the protection scope of the present invention.

In the specification, claims, and accompanying drawings of the present invention, the terms "first", "second", and the like (if any) are intended to distinguish between similar objects but do not necessarily indicate a specific order or sequence. It should be understood that data termed in such a way are interchangeable in proper circumstances, so that embodiments described herein can be implemented in other orders than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The following first briefly describes some concepts that may be used in embodiments of the present invention.

Electromechanical coupling coefficient K²: As a key parameter of a resonator, the electromechanical coupling coefficient K² can reflect efficiency of conversion between mechanical energy and electric energy. The electromechanical coupling coefficient K² of the resonator determines a difference between a serial resonance frequency and a parallel resonance frequency of the resonator. When the resonator is used in a design of a filter, the difference directly determines a bandwidth of the filter. It may be considered that a higher electromechanical coupling coefficient K² indicates higher conversion efficiency and better performance of the resonator.

Quality factor Q: The quality factor Q represents energy utilization of a device, namely, a ratio of total energy received by the device to energy consumed within a vibration cycle. In the design of the filter, the electromechanical coupling coefficient K² and the quality factor Q of the resonator constituting the filter are both important parameters.

Euler angle (Euler angle) of a piezoelectric material: In a bulk acoustic wave (Bulk Acoustic Wave, BAW) resonator, an Euler angle (Euler angle) representation is a method of representing a crystallographic direction of a surface normal of a wafer and a reference plane direction that coincides with a propagation direction of the bulk acoustic wave BAW resonator. The Euler angle may also be referred to as a cut angle.

Slowness characteristic and slowness curve: The slowness characteristic is usually represented by the slowness curve. The slowness characteristic is a physical parameter that measures propagation of a wave in a medium. Slowness is the reciprocal of velocity. Therefore, propagation time of the wave is a propagation distance of the wave multiplied by the slowness of the medium.

An embodiment provides an electronic device 1000. The electronic device 1000 includes but is not limited to products such as a radio frequency front-end and a filtering and amplification module, and may further include a mobile phone (Mobile phone), a tablet computer (Pad), an intelligent wearable product (for example, a smart watch or a smart band), a virtual reality (Virtual Reality, VR) device, augmented reality (Augmented Reality, AR), an unmanned aerial vehicle, and the like. A household electronic product is, for example, a smart door lock, a television, a remote control, a refrigerator, or a small household charging appliance (for example, a soy milk maker or a robot vacuum). A vehicle-mounted electronic product is, for example, a vehicle-mounted navigator or a vehicle-mounted high-density digital video disc (Digital Video Disc, DVD). A financial terminal product is, for example, an automated teller machine (Automated Teller Machine, ATM) or a terminal for self-help service handling. A specific form of the foregoing communication device is not specially limited in embodiments of this application.

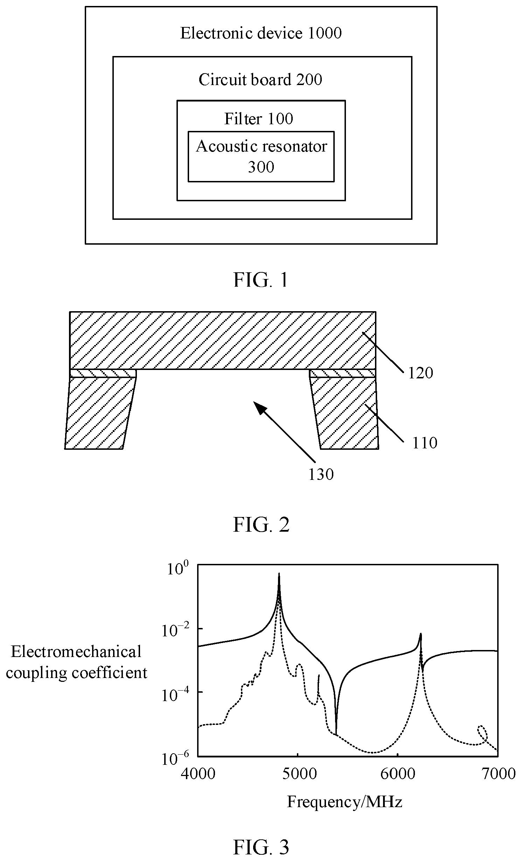

FIG. 1 is a block diagram of a structure of an electronic device 1000 according to an embodiment. The electronic device 1000 may include a filter 100 and a circuit board 200. The filter 100 is disposed on the circuit board 200. Under control of the circuit board 200, the filter 100 may perform conversion from an electrical signal to an acoustic signal (acoustic wave) and then back to an electrical signal. In the conversion process, the filter 100 may effectively filter out a frequency of a specific frequency point or a frequency other than the frequency point in a signal, to obtain a signal of a specific frequency or a signal obtained after removing a specific frequency, so as to improve working performance of the electronic device.

Currently, the filter 100 is still mainly an acoustic filter with a small size, for example, may be a low-pass acoustic filter, a high-pass acoustic filter, a band-pass acoustic filter, a bandstop acoustic filter, or an active acoustic filter. Traditional acoustic filters are classified into a surface acoustic wave filter (Sound Surface Wave Filter, SAW) and a bulk acoustic wave filter (Bulk Acoustic Wave Filter, BAW). The SAW filter is mainly applied to a low frequency, and the BAW filter is mainly applied to a high frequency above 2 GHz. However, for a new large-bandwidth frequency band in 5G communication, it is difficult to meet a design requirement of a large-bandwidth filter in 5G communication by using a conventional SAW/BAW technology. Therefore, the filter needs to meet a design requirement of a large bandwidth.

To increase the bandwidth of the filter, a resonator used as a design unit of the filter needs to have a higher electromechanical coupling coefficient. In this embodiment, the filter 100 may include a plurality of acoustic resonators 300 connected in series, or include a plurality of acoustic resonators 300 connected in parallel, or include acoustic resonators 300 connected in series and parallel.

The acoustic resonators 300 may be classified into a bulk acoustic wave (Bulk Acoustic Wave, BAW) resonator, a surface acoustic wave (Surface Acoustic Wave, SAW) resonator, a laterally-excited bulk acoustic wave resonator, a solid-assembled laterally-excited bulk acoustic wave resonator, and the like.

For example, the laterally-excited bulk acoustic wave resonator has a higher resonance frequency (>3.7 GHz) than the conventional SAW resonator, and has a larger bandwidth than the BAW resonator, and may be used to fabricate a large-bandwidth 5G or 6G filter. FIG. 2 is a cross-sectional diagram of a laterally-excited bulk acoustic wave resonator according to an embodiment. The laterally-excited bulk acoustic wave resonator has a silicon substrate 110 and a piezoelectric layer 120 located above the silicon substrate 110. A cavity 130 is formed inside the silicon substrate 110, to confine acoustic wave energy within the piezoelectric layer 120 through the cavity 130. This avoids leakage of the acoustic wave energy through the silicon substrate 110, thereby ensuring that the laterally-excited bulk acoustic wave resonator obtains a high quality factor Q.

Therefore, FIG. 3 is an admittance curve diagram of a laterally-excited bulk acoustic wave resonator according to an embodiment. It can be seen from an admittance curve in FIG. 3 that a horizontal coordinate is a frequency, and a vertical coordinate is Y11. A highest point of the curve is a resonance point, and a frequency corresponding to the point is a resonance frequency (resonance frequency, fr). A lowest point of the curve is an anti-resonance point, and a frequency corresponding to the point is an anti-resonance frequency (anti-resonance frequency, fa). A quality factor Q of the laterally-excited bulk acoustic wave resonator may be reflected by the highest point and the lowest point. Further, it can be seen from smoothness of the curve that, spurious mode suppression of the laterally-excited bulk acoustic wave resonator is obvious. In addition, it can be learned from peaks and troughs of the curve that, a larger bandwidth of the resonator indicates a higher electromechanical coupling coefficient, and similarly, a higher electromechanical coupling coefficient of the resonator indicates a larger bandwidth.

However, as shown in FIG. 2, due to the cavity 130 below the piezoelectric layer 120 of the laterally-excited bulk acoustic wave resonator, a piezoelectric layer thin film of the laterally-excited bulk acoustic wave resonator easily collapses after processing. Consequently, a power capacity of the laterally-excited bulk acoustic wave resonator is lower than that of the conventional SAW and BAW. In contrast, the solid-assembled laterally-excited bulk acoustic wave resonator can be used to resolve a problem of the power capacity of the laterally-excited bulk acoustic wave resonator. However, an electromechanical coupling coefficient and a quality factor Q of the resonator in a solid-assembled laterally-excited bulk acoustic wave resonator structure are greatly reduced compared with those of a structure of a conventional resonator. Therefore, FIG. 3 is a curve of a relationship between a frequency and an electromechanical coupling coefficient in a solid-assembled laterally-excited bulk acoustic wave resonator. A horizontal coordinate is a frequency, a vertical coordinate is an electromechanical coupling coefficient, a solid line is a curve of the electromechanical coupling coefficient and the frequency of the conventional resonator, and a solid line is a curve of the electromechanical coupling coefficient and the frequency of the solid-assembled laterally-excited bulk acoustic wave resonator. It can be learned from FIG. 3 that, a decrease in the electromechanical coupling coefficient of the solid-assembled laterally-excited bulk acoustic wave resonator is likely to occur at a higher frequency. As a result, the resonator currently has a problem that the power capacity and the electromechanical coupling coefficient cannot be balanced at the same time.

Based on at least the foregoing two problems of the resonator, an embodiment of this application provides an acoustic resonator 300, applied to the foregoing filter 100, to resolve a problem that the power capacity and electromechanical coupling coefficient cannot be balanced at the same time, and suppress a spurious response of the acoustic resonator 300, thereby improving a quality factor Q of the acoustic resonator 300.

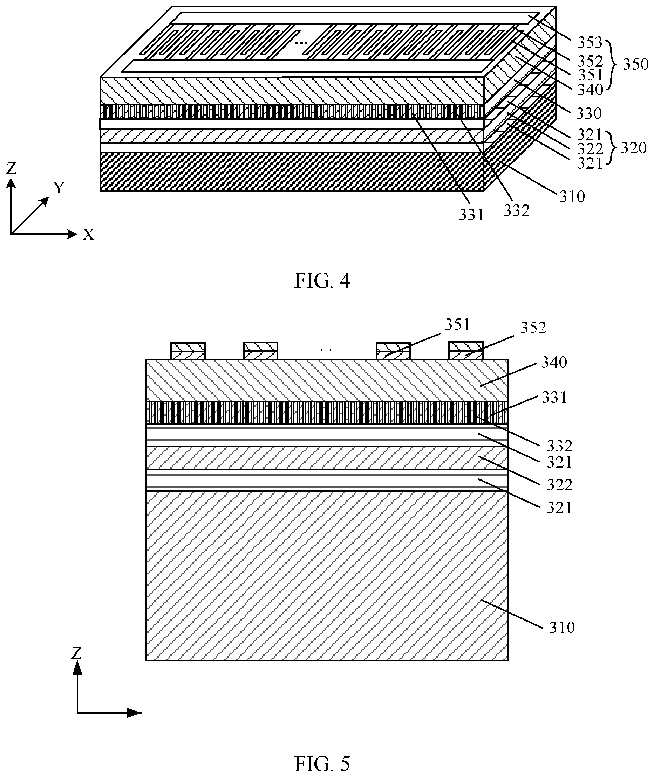

FIG. 4 is a diagram of a three-dimensional structure of an acoustic resonator 300 according to an embodiment of this application. The acoustic resonator 300 may include a substrate layer 310, a piezoelectric transducer structure layer 350, and an energy adjustment layer 330. The piezoelectric transducer structure layer 350 is disposed on one side of the substrate layer 310. The energy adjustment layer 330 is disposed between the substrate layer 310 and the piezoelectric transducer structure layer 350, where the energy adjustment layer 330 includes a plurality of confinement grooves 331, and each confinement groove 331 passes through at least a surface that is of the energy adjustment layer 330 and that faces the piezoelectric transducer structure layer 350.

The energy adjustment layer 330 concentrates acoustic wave energy on the piezoelectric transducer structure layer 350 through the plurality of confinement grooves 331. This helps improve an electromechanical coupling coefficient of the acoustic resonator 300. Then, a main vibration mode of the acoustic resonator 300 can be adjusted by adjusting an arrangement quantity and an arrangement spacing of the confinement grooves 331, so that a slowness curve of the main vibration mode of the acoustic resonator 300 is flattened, and a lateral mode of the acoustic resonator 300 is suppressed. This suppresses a spurious response of the acoustic resonator 300, thereby improving a quality factor Q of the acoustic resonator 300. In addition, the piezoelectric transducer structure layer 350 can be supported through parts that are of the energy adjustment layer 330 and that are between adjacent confinement grooves 331, so that stability of the piezoelectric transducer structure layer 350 is improved.

The substrate layer 310 may be made of a substrate material such as Si, sapphire, or SiC. A material of the energy adjustment layer 330 may include at least one of SiO₂, SiOC, Si₃N₄, AlN, Pt, Mo, W, and HfO₂, or another material.

For example, each confinement groove 331 further passes through a surface that is of the energy adjustment layer 330 and that faces away from the piezoelectric transducer structure layer 350, that is, the confinement grooves 331 pass through the entire energy adjustment layer 330, so that the acoustic wave energy enters the confinement grooves 331 and is concentrated on one side of the piezoelectric transducer structure layer 350, thereby improving an effect of concentrating the acoustic wave energy through the confinement grooves 331.

In this example, the confinement grooves 331 may be formed through etching by using a deep reactive ion etching (Deep RIE) technology. Confinement grooves 331 of different shapes and different extension directions may be formed by etching the energy adjustment layer 330. The following further describes embodiments of etching directions of the confinement grooves 331.

For ease of description, a length direction of a part of the acoustic resonator 300 captured in FIG. 4 is defined as an X-axis, a width direction of the acoustic resonator 300 is defined as a Y-axis, and a thickness direction of the acoustic resonator 300 is defined as a Z-axis. It may be understood that a coordinate system of the acoustic resonator 300 may be flexibly set according to a specific actual requirement.

### Embodiment 1

In this embodiment, the energy adjustment layer 330 is etched along one direction to form the confinement grooves 331. FIG. 4 is a diagram of a three-dimensional structure of an acoustic resonator 300 according to an embodiment of this application when a second direction is perpendicular to a first direction. The piezoelectric transducer structure layer 350 includes a piezoelectric material layer 340 and an interdigital transducer structure located on a side that is of the piezoelectric material layer 340 and that faces away from the substrate layer 310, the interdigital transducer structure includes a plurality of first interdigital electrodes 351 and a plurality of second interdigital electrodes 352 that are disposed in an interdigitated manner and opposite to each other along the first direction, and the first direction is parallel to the substrate layer 310. The confinement groove 331 extends from one of two opposite sides of the energy adjustment layer 330 in the second direction to the other side, the second direction is parallel to the substrate layer 310, and the second direction is parallel to or perpendicular to the first direction.

Still refer to FIG. 4. The interdigital transducer structure further includes a pair of busbars 353 disposed opposite to each other. The plurality of first interdigital electrodes 351 and the plurality of second interdigital electrodes 352 are respectively connected to the two busbars 353. The first interdigital electrodes 351 have two groups of end parts, and the second interdigital electrodes 352 have two groups of end parts, where one group of end parts is connected to the busbar 353, and the other group of end parts is spaced apart from the busbar 353. The two busbars 353 both extend along a direction of the X-axis, and the first interdigital electrodes 351 and the second interdigital electrodes 352 extend along a direction of the Y-axis. That is, the first interdigital electrodes 351 and the second interdigital electrodes 352 are all perpendicular to the busbars 353.

It can be learned that the first interdigital electrodes 351 and the second interdigital electrodes 352 are disposed in an interdigitated manner along the direction of the x-axis, that is, the first direction is the direction of the x-axis. In this way, the acoustic wave energy is reflected back and forth in the piezoelectric material layer 340 to form oscillation, thereby achieving a transduction function of the acoustic resonator 300. In addition, the first interdigital electrodes 351 and the second interdigital electrodes 352 are distributed more compactly, so that space occupied by the first interdigital electrodes 351 and the second interdigital electrodes 352 is reduced.

Further, the second direction along which the confinement groove 331 extends is related to the first direction. Therefore, it should be noted that, when the confinement groove 331 is formed through processing on the energy adjustment layer 330 along the second direction, the second direction can be determined with reference to the first direction, and the energy adjustment layer 330 is etched by using the deep reactive ion etching (DeepRIE) technology. It can be learned that the second direction is the etching direction of the confinement groove 331.

For example, when the second direction is perpendicular to the first direction, FIG. 4 is a diagram of a three-dimensional structure of the acoustic resonator 300 according to an embodiment of this application, and it may be understood that FIG. 4 is a diagram of a three-dimensional structure of the acoustic resonator 300 when the first direction is perpendicular to the first direction; and FIG. 5 is a cross-sectional diagram of the acoustic resonator 300 in an X-Z direction according to an embodiment. It can be learned from FIG. 4 and FIG. 5 that, an extension direction of the confinement groove 331 is perpendicular to a direction in which the first interdigital electrodes 351 and the second interdigital electrodes 352 are spaced apart.

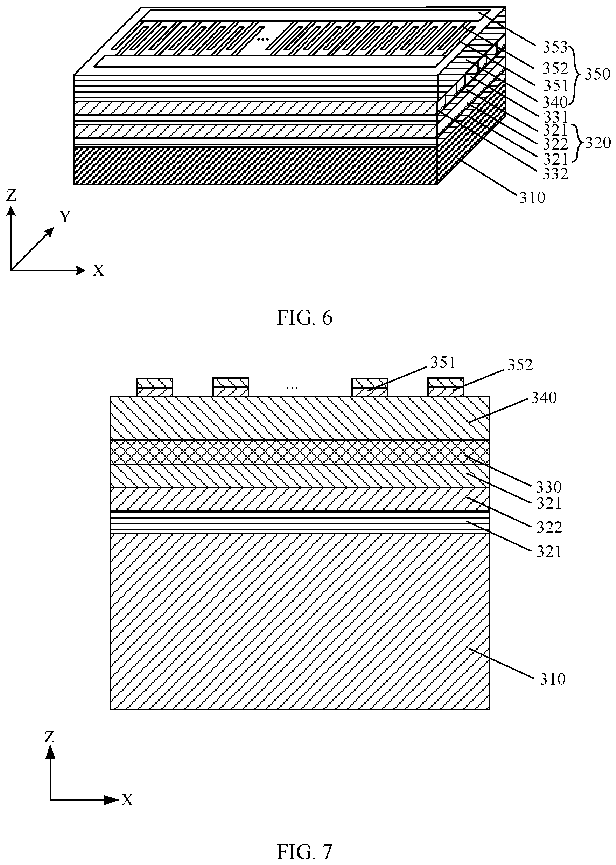

For example, when the second direction is parallel to the first direction, FIG. 6 is a diagram of a three-dimensional structure of the acoustic resonator 300 according to an embodiment of this application when the first direction is parallel to the second direction, and FIG. 7 is a cross-sectional diagram of the acoustic resonator 300 in an X-Z direction according to an embodiment. It can be learned from FIG. 6 and FIG. 7 that, an extension direction of the confinement groove 331 is parallel to a direction in which the first interdigital electrodes 351 and the second interdigital electrodes 352 are spaced apart.

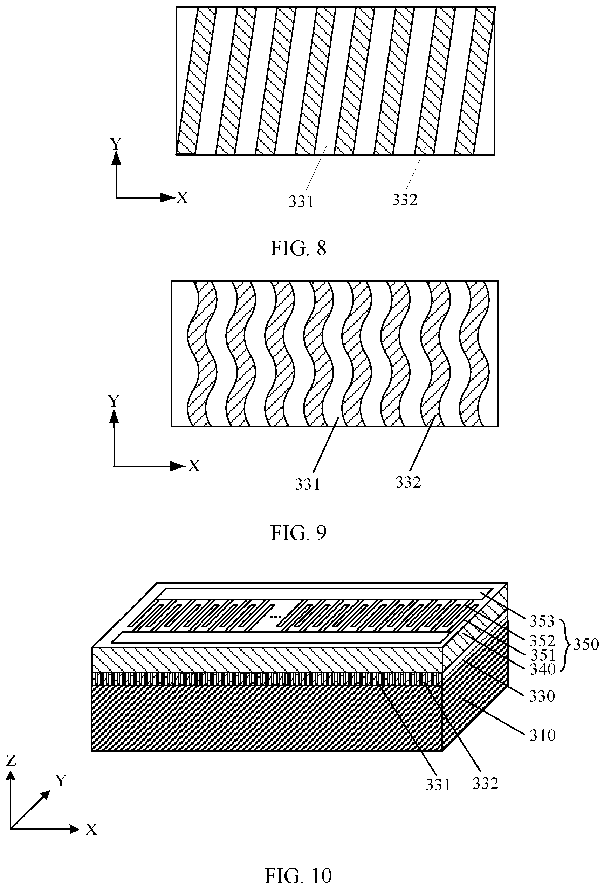

However, regardless of whether the second direction is perpendicular to or parallel to the first direction, a cross-sectional shape of the energy adjustment layer 330 in an X-Y direction meets the following case. For example, FIG. 8 is a cross-sectional diagram of confinement grooves 331 whose cross-sectional shapes are straight strips in the X-Y direction according to an embodiment. It may be understood that, an extension direction of each confinement groove 331 is parallel to the second direction, or may form an acute angle of less than 60° with the second direction. In this embodiment, the extension direction of the confinement groove 331 may form the acute angle of less than 60° with the second direction, and the confinement grooves 331 are spaced side by side along a direction perpendicular to the second direction. In this way, the energy adjustment layer 330 is directly etched along the second direction, so that time for etching the energy adjustment layer 330 to form the confinement grooves 331 is shortened.

For another example, FIG. 9 is a cross-sectional diagram of confinement grooves 331 whose cross-sectional shapes are wavy in the X-Y direction according to an embodiment. It may be understood that the confinement groove 331 may be wavy, a line connecting two ends of the confinement groove extends along the second direction, and the confinement grooves 331 are spaced side by side along a direction perpendicular to the second direction. The wave-shaped confinement grooves 331 can be used in the acoustic resonator 300 to increase space occupied by the confinement grooves 331 on the energy adjustment layer 330, thereby increasing space for concentrating the acoustic wave energy on the piezoelectric material layer 340 through the confinement grooves 331, and enhancing a capability of concentrating the acoustic wave energy through the confinement grooves 331.

Refer to FIG. 8 and FIG. 9. In this embodiment, the energy adjustment layer 330 may further include dividing parts 332, and the dividing parts 332 divide the energy adjustment layer 330 into the plurality of confinement grooves 331. The dividing parts 332 are spaced apart along the second direction. Cross-sectional shapes of the dividing parts 332 in a direction parallel to the substrate layer 310 may include any one of parallel strips, parallel oblique strips, and parallel wave strips.

The dividing parts 332 may occupy a range of 1% to 99% of an area of the energy adjustment layer 330. A duty cycle of the dividing parts 332 includes a cross-sectional area of the dividing parts 332 along the direction parallel to the substrate layer 310 within one array period/a total area of the dividing parts 332 and the confinement grooves 331 within one array period. For the array period herein, according to an actual requirement, as shown in FIG. 8 and FIG. 9, eight columns of dividing parts 332 are selected as one array period. In the array period of eight columns, a duty cycle of the dividing parts 332 ranges from 1% to 99%. It should be noted that a range of an area of the energy adjustment layer 330 occupied by the confinement grooves 331 is greater than the range of the area of the energy adjustment layer 33 occupied by the dividing parts 332, which helps improve the electromechanical coupling coefficient of the acoustic resonator 300.

It can be learned that, after the acoustic wave energy is concentrated on the piezoelectric material layer 340 through the confinement grooves 331, electric energy may be converted into acoustic energy by using a piezoelectric effect of the piezoelectric material layer 340, so that the piezoelectric material layer 340 reflects the acoustic wave energy. In this way, the acoustic wave energy forms standing wave oscillation between the substrate layer 310 and the piezoelectric material layer 340, thereby reducing the acoustic loss of the acoustic resonator 300.

To meet different electromechanical coupling coefficients required, different materials may be selected for the piezoelectric material layer 340, or different material Euler angle tangential directions may be selected for the piezoelectric material layer 340. For example, for a material of the piezoelectric material layer 340, refer to Table 1.

**Table 1**

| Piezoelectric material | Chemical abbreviation | Remarks |
|---|---|---|
| Quartz | Main component SiO₂ | Small piezoelectric coefficient |
| Lithium niobate | LN | Select a tangential direction |
| | | as required |
| Lithium tantalate | LT | Select a tangential direction as required |
| Aluminum nitride | AlN | |
| Scandium-doped aluminum nitride | ScₓAlN₁₋ₓ | X: ratio of doped |

It should be noted that different materials of the piezoelectric material layer 340 have different anisotropy features, and different Euler angle tangential directions of a same material of the piezoelectric material layer 340 have different anisotropy features. Therefore, to suppress the lateral mode of the acoustic resonator 300, the piezoelectric material layer 340 is designed based on anisotropy features of a material in a horizontal direction.

For example, a single-layer electrode, namely, a single-layer metal, may alternatively be used for the interdigital transducer structure, or an electrode layer may be formed by superposition and combination of different metals.

In this embodiment, to obtain a high electromechanical coupling coefficient, for materials of the first interdigital electrodes 351 and the second interdigital electrodes 352, refer to Table 2.

**Table 2**

| Electrode material | Chemical formula |
|---|---|
| Ruthenium | Ru |
| Molybdenum | Mo |
| Platinum | Pt |
| Tungsten | W |
| Aluminum | Al |
| Gold | Au |
| Silver | Ag |
| Copper | Cu |

For the acoustic resonator 300 in which the first interdigital electrodes 351 and the second interdigital electrodes 352 are disposed in an interdigitated manner, using the foregoing electrode materials as the materials of the first interdigital electrodes 351 and the second interdigital electrodes 352 provides a characteristic of large acoustic impedance, and helps achieve a high electromechanical coupling coefficient.

In this embodiment, the acoustic resonator 300 further includes a Bragg reflection layer 320. FIG. 4 is a diagram of a three-dimensional structure of the acoustic resonator 300 according to an embodiment of this application. It can be learned from FIG. 4 that the Bragg reflection layer 320 is located between the substrate layer 310 and the energy adjustment layer 330. It should be noted that the Bragg reflection layer 320 may be formed by alternating a high acoustic impedance material and a low acoustic impedance material. It may be understood that, in a Z direction, the Bragg reflection layer 320 may be formed by a plurality of alternating layers of the high acoustic impedance material and the low acoustic impedance material, and in this embodiment, the Bragg reflection layer 320 is formed by three alternating layers.

It should be noted that the Bragg reflection layer 320 may reflect the acoustic wave energy back to the inside of the piezoelectric material layer 340, so that the acoustic wave energy is concentrated on the piezoelectric material layer 340. The Bragg reflection layer 320 includes a high acoustic velocity layer 321 and a low acoustic velocity layer 322. As shown in FIG. 4, three alternating layers of the high acoustic velocity layer 321 and the low acoustic velocity layer 322 are stacked, where the high acoustic velocity layer 321 away from the substrate layer 310 is close to the energy adjustment layer 330.

The high acoustic velocity layer 321 is a high acoustic impedance layer, and is usually made of a material having a high dielectric constant. The low acoustic velocity layer 322 is a low acoustic impedance layer, and is usually made of a material having a low dielectric constant. The high acoustic velocity layer 321 and the low acoustic velocity layer 322 are alternately stacked, to improve performance of a device.

This embodiment provides a material matching table of the high acoustic impedance layer and the low acoustic impedance layer. Refer to Table 3.

**Table 3**

| High acoustic impedance layer/Low acoustic impedance layer |
|---|
| SiO₂/W |
| SiOC/Pt |
| SiO₂/Mo |
| SiO₂/Pt |
| SiO₂/TiN |
| SiO₂/AlN |
| SiO₂/Ta₂O₅ |
| SiO₂/HfO₂ |
| Si₃N₄/W |
| Si₃N₄/Mo |

In addition, both the high acoustic impedance layer and the low acoustic impedance layer may be configured to control a resonance frequency and an amplitude of the device, to meet different application requirements.

### Embodiment 2

A difference between this embodiment and Embodiment 1 is that there is no Bragg reflection layer 320 between the substrate layer 310 and the energy adjustment layer 330.

For example, FIG. 10 is a diagram of a three-dimensional structure of an acoustic resonator 300 according to an embodiment when there is no Bragg reflection layer 320 and a second direction is perpendicular to a first direction. It can be learned from FIG. 10 that an extension direction of the confinement groove 331, namely, the second direction, is perpendicular to the first direction.

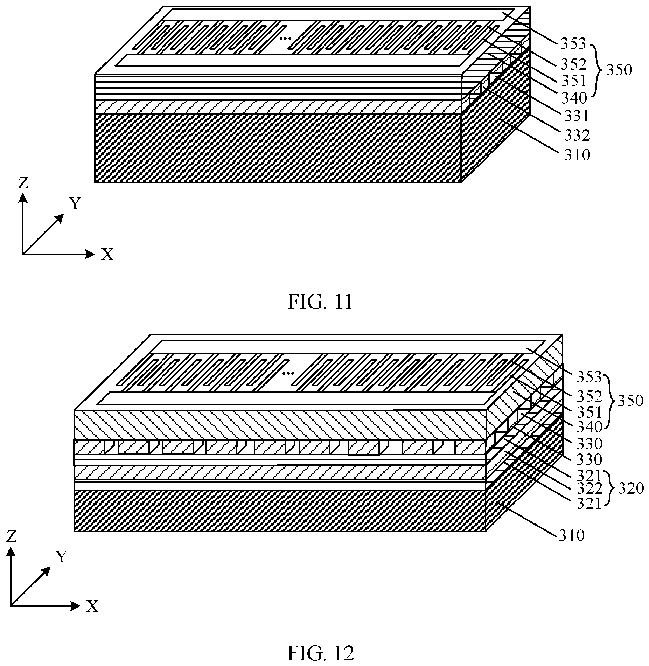

For example, FIG. 11 is a diagram of a three-dimensional structure of an acoustic resonator 300 according to an embodiment when there is no Bragg reflection layer 320 and a second direction is parallel to a first direction. It may be understood that an extension direction of the confinement groove 331 in FIG. 11, namely, the second direction, is parallel to the first direction.

In the foregoing two examples without the Bragg reflection layer 320, the confinement grooves 331 are formed through etching in two manners: one in which the second direction is parallel to the first direction, and the other in which the second direction is perpendicular to the first direction, to reduce processing difficulty of the acoustic resonator 300, so that a gap on one side of the piezoelectric material layer 340 is increased through the energy adjustment layer 330, and the power capacity of the acoustic resonator 300 is improved with a small loss in the electromechanical coupling coefficient.

### Embodiment 3

A difference between this embodiment and Embodiment 1 is that the energy adjustment layer 330 is etched along two directions to form the confinement grooves 331.

For example, FIG. 12 is a diagram of a three-dimensional structure of an acoustic resonator 300 according to an embodiment when the confinement grooves 331 are formed through etching along a second direction and a third direction. A part of the confinement grooves 331 extends along the second direction, the other part of the confinement grooves 331 extends along the third direction, and the second direction is not parallel to the third direction, so that processing on the energy adjustment layer 330 is performed along the two different directions. This increases selectability of the etching directions of the confinement grooves 331, and facilitates adjustment of a processing direction of the energy adjustment layer 330, thereby improving convenience of processing the confinement grooves 331.

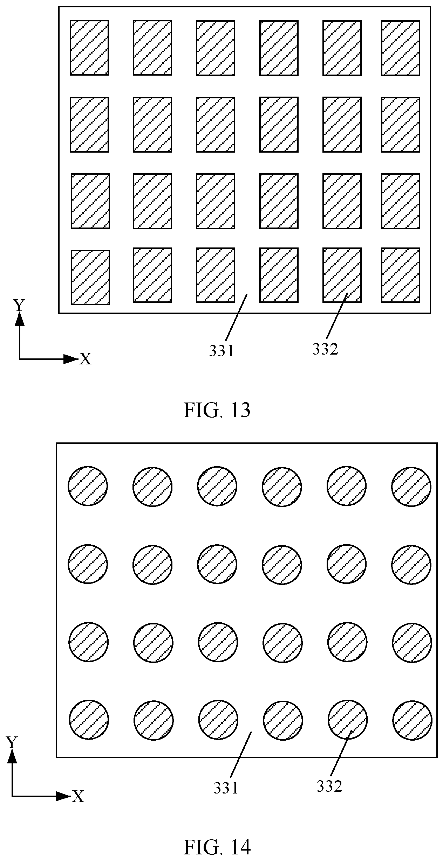

For example, FIG. 13 is a cross-sectional diagram of confinement grooves 331 according to an embodiment when the second direction is perpendicular to the third direction. The plurality of confinement grooves 331 may include a plurality of first grooves and a plurality of second grooves, the first groove extends from one of two opposite sides of the energy adjustment layer 330 in the second direction to the other side, the second groove extends from one of two opposite sides of the energy adjustment layer 330 in the third direction to the other side, and the third direction is not parallel to the second direction. In FIG. 13, the third direction is perpendicular to the second direction, the second direction is parallel to or perpendicular to the first direction, and the third direction is also parallel to or perpendicular to the first direction. In this way, the plurality of first grooves and the plurality of second grooves are disposed in an interdigitated manner and spaced apart, so that a distribution ratio of the confinement grooves 331 on the energy adjustment layer 330 is increased. This increases a proportion of the confinement grooves 331 on the energy adjustment layer 330, thereby helping improve an effect of concentrating the acoustic wave energy through the confinement grooves 331.

It can be further learned that the energy adjustment layer 330 is etched along the second direction and the third direction to form the confinement grooves 331, so that dividing parts 332 are formed between the plurality of first grooves and the plurality of second grooves. Cross-sectional shapes of the dividing parts 332 in a direction parallel to the substrate layer 310 may include any one of circles, ellipses, parallel quadrilaterals, diamonds, squares, rectangles, or polygons. As shown in FIG. 13, the cross-sectional shapes of the dividing parts in the direction parallel to the substrate layer 310 are rectangles. FIG. 14 is a cross-sectional diagram of dividing parts 332 whose cross-sectional shapes are circular on an X-Y plane according to an embodiment. The cross-sectional shapes of the dividing parts 332 in a direction parallel to the substrate layer 310 are circular.

In this embodiment, the dividing parts 332 occupy a range of 1% to 99% of an area of the energy adjustment layer 330. A duty cycle of the dividing parts 332 includes a cross-sectional area of the dividing parts 332 along the direction parallel to the substrate layer 310 within one array period/a total area of the dividing parts 332 and the confinement grooves 331 within one array period. For the array period herein, according to an actual requirement, as shown in FIG. 13 and FIG. 14, four rows and six columns of dividing parts 332 are selected as one array period. In the array period of four rows and six columns, a duty cycle of the dividing parts 332 also ranges from 1% to 99%. It should be noted that a range of an area of the energy adjustment layer 330 occupied by the confinement grooves 331 may be greater than the range of the area of the energy adjustment layer 33 occupied by the dividing parts 332, which helps improve the electromechanical coupling coefficient of the acoustic resonator 300.

In conclusion, in this embodiment, the energy adjustment layer 330 is added, and an arrangement quantity and an arrangement spacing of the confinement grooves 331 are adjusted, so that the electromechanical coupling coefficient of the acoustic resonator 300 is adjusted, and the power capacity of the laterally-excited bulk acoustic wave resonator is improved. This balances the electromechanical coupling coefficient and the power capacity, thereby improving the quality factor Q of the acoustic resonator 300.

Therefore, this embodiment further provides a curve diagram to show a design effect of the acoustic resonator 300.

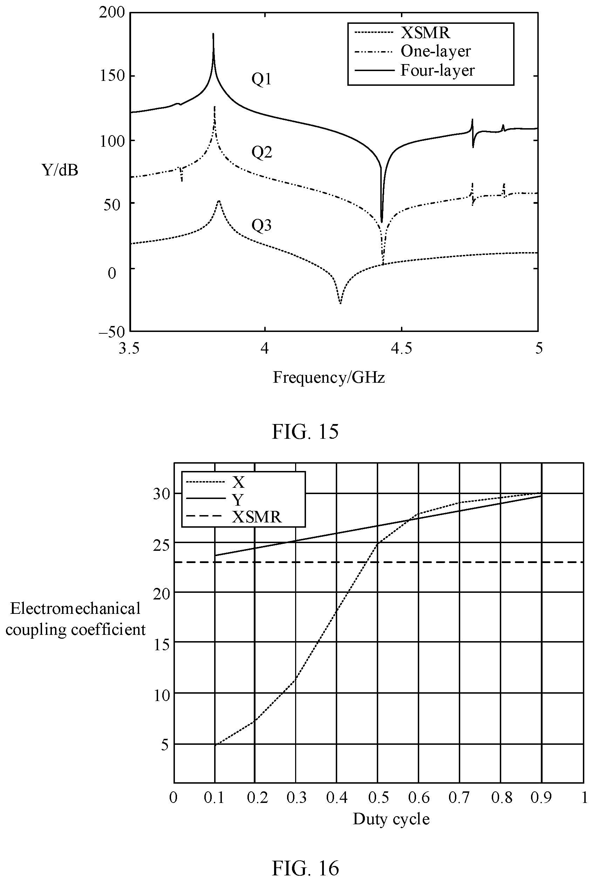

FIG. 15 is a curve diagram of a relationship between a frequency and a quality factor Q of an acoustic resonator 300 according to an embodiment. In FIG. 15, a horizontal coordinate is a frequency, and a vertical coordinate is a Y amplitude value. Three curves in the figure are all quality factors Q. For ease of comparison, the three curves in the figure are respectively shifted by 50 dB on a vertical axis to facilitate observation and comparison of the three curves, where the three curves are named Q1, Q2, and Q3. Q1 is a four-layer energy adjustment layer 330, Q2 is a one-layer energy adjustment layer 330, and Q3 is a solid-assembled laterally-excited bulk acoustic wave resonator. It can be learned from FIG. 15 that a larger impedance ratio of the resonance point/anti-resonance point admittance curve indicates a higher quality factor Q, which is intuitively reflected in that a sharper admittance curve of the two points indicates a higher quality factor Q, and Q1>Q2>Q3.

FIG. 16 is a curve diagram of an electromechanical coupling coefficient of an acoustic resonator 300 etched along an X direction and a Y direction according to an embodiment. In FIG. 16, a horizontal coordinate is a duty cycle of the confinement grooves 331, and a vertical coordinate is an electromechanical coupling coefficient. In this embodiment, the energy adjustment layer 330 may be etched in the X direction and the Y direction. Therefore, electromechanical coupling coefficients corresponding to confinement grooves 331 obtained in the two etching manners are compared with an electromechanical coupling coefficient of a solid-assembled laterally-excited bulk acoustic wave resonator. It can be learned from FIG. 16 that the electromechanical coupling coefficient of the energy adjustment layer 330 etched in the X direction or the Y direction is higher than the electromechanical coupling coefficient of the solid-assembled laterally-excited bulk acoustic wave resonator. In addition, compared with a case of using a multi-layer Bragg reflection layer 320, in this embodiment, the power capacity of the acoustic resonator 300 can be improved through a one-layer energy adjustment layer 330 at a cost of a small loss in the electromechanical coupling coefficient, so that characteristics of the electromechanical coupling coefficient and the power capacity of the acoustic resonator 300 are balanced.

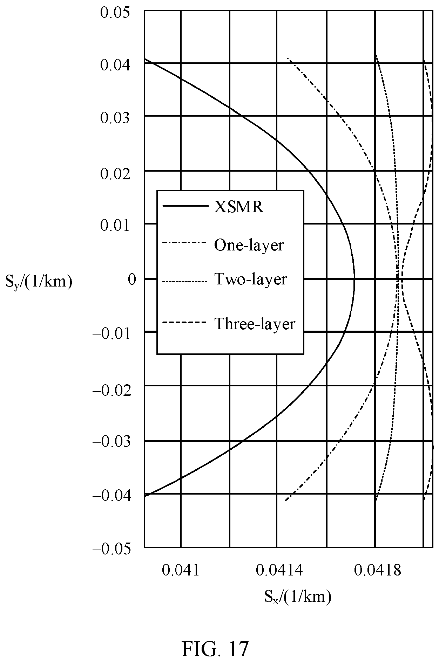

FIG. 17 is a slowness curve diagram of an acoustic resonator 300 in an X-Y direction according to an embodiment. In FIG. 17, a solid line is a slowness curve of a solid-assembled laterally-excited bulk acoustic wave resonator, and dashed lines are slowness curves of energy adjustment layers 330 with different layers. It can be seen from FIG. 17 that a slowness curve of the acoustic resonator 300 with the energy adjustment layer 330 is flatter, and more layers of the energy adjustment layer 330 indicate a flatter slowness curve of the acoustic resonator 300. In this way, a slowness curve of a main vibration mode of the acoustic resonator 300 can be adjusted by adjusting a quantity and a spacing of acoustic impedance parts, so that when the slowness curve of the main vibration mode is flattened, a lateral mode can be suppressed, thereby improving the quality factor Q of the acoustic resonator 300.

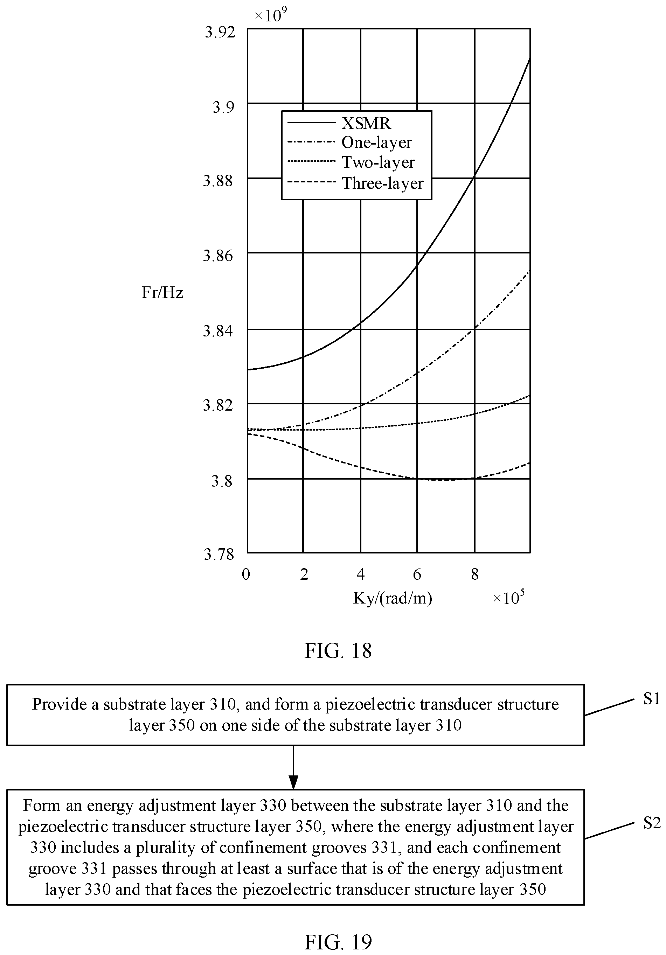

FIG. 18 is a comparison diagram of dispersion curves of an acoustic resonator 300 according to an embodiment. In FIG. 18, a solid line is a dispersion curve of a solid-assembled laterally-excited bulk acoustic wave resonator, and dashed lines are dispersion curves of energy adjustment layers 330 with different layers. It can be seen from FIG. 18 that a dispersion curve of the acoustic resonator 300 with the energy adjustment layer 330 is flatter, and more layers of the energy adjustment layer 330 indicate a flatter slowness curve of the acoustic resonator 300, so that suppression of a lateral mode of the acoustic resonator 300 is more obvious.

An embodiment of this application further provides a preparation method for an acoustic resonator 300. FIG. 19 is a flowchart of the preparation method for the acoustic resonator 300 according to an embodiment. The preparation method includes S1 and S2.

S1: Provide a substrate layer 310, and form a piezoelectric transducer structure layer 350 on one side of the substrate layer 310.

S2: Form an energy adjustment layer 330 between the substrate layer 310 and the piezoelectric transducer structure layer 350, where the energy adjustment layer 330 includes a plurality of confinement grooves 331, and each confinement groove 331 passes through at least a surface that is of the energy adjustment layer 330 and that faces the piezoelectric transducer structure layer 350.

In this embodiment, the energy adjustment layer 330 is etched along a second direction and/or a third direction, to form confinement grooves 331 that are spaced side by side or confinement grooves 331 that are disposed in an interdigitated manner, so that a structure in which dividing parts 332 and the confinement grooves 331 are alternately stacked is formed between the substrate layer 310 and the piezoelectric material layer 340. In this way, the piezoelectric material layer 340 is supported through the dividing parts 332, and acoustic wave energy is concentrated on the piezoelectric material layer 340 through the confinement grooves 331, thereby improving an electromechanical coupling coefficient of the acoustic resonator 300.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An acoustic resonator, comprising:
a substrate layer;
a piezoelectric transducer structure layer, disposed on one side of the substrate layer; and
an energy adjustment layer, disposed between the substrate layer and the piezoelectric transducer structure layer, wherein the energy adjustment layer comprises a plurality of confinement grooves, and each confinement groove passes through at least a surface that is of the energy adjustment layer and that faces the piezoelectric transducer structure layer.

2. The acoustic resonator according to claim 1, wherein each confinement groove further passes through a surface that is of the energy adjustment layer and that faces away from the piezoelectric transducer structure layer.

3. The acoustic resonator according to claim 1 or 2, wherein the piezoelectric transducer structure layer comprises a piezoelectric material layer and an interdigital transducer structure located on a side that is of the piezoelectric material layer and that faces away from the substrate layer, the interdigital transducer structure comprises a plurality of first interdigital electrodes and a plurality of second interdigital electrodes that are disposed in an interdigitated manner and opposite to each other along a first direction, and the first direction is parallel to the substrate layer; and
the confinement groove extends from one of two opposite sides of the energy adjustment layer in a second direction to the other side, the second direction is parallel to the substrate layer, and the second direction is parallel to or perpendicular to the first direction.

4. The acoustic resonator according to claim 3, wherein an extension direction of each confinement groove is parallel to the second direction, or forms an acute angle of less than 60° with the second direction.

5. The acoustic resonator according to claim 4, wherein the confinement groove is wavy, and a line connecting two ends of the confinement groove extends along the second direction.

6. The acoustic resonator according to claim 4, wherein a part of the confinement grooves extends along the second direction, the other part of the confinement grooves extends along a third direction, and the second direction is not parallel to the third direction.

7. The acoustic resonator according to claim 4, wherein the plurality of confinement grooves comprise a plurality of first grooves and a plurality of second grooves, the first groove extends from one of two opposite sides of the energy adjustment layer in the second direction to the other side, the second groove extends from one of two opposite sides of the energy adjustment layer in a third direction to the other side, and the third direction is not parallel to the second direction.

8. The acoustic resonator according to any one of claims 1 to 7, further comprising a Bragg reflection layer, wherein the Bragg reflection layer is located between the substrate layer and the energy adjustment layer.

9. The acoustic resonator according to any one of claims 1 to 8, wherein the energy adjustment layer further comprises dividing parts, the dividing parts divide the energy adjustment layer into the plurality of confinement grooves, and the dividing parts occupy a range of 1% to 99% of an area of the energy adjustment layer.

10. The acoustic resonator according to any one of claims 1 to 9, wherein a material of the energy adjustment layer comprises at least one of SiO₂, SiOC, Si₃N₄, AlN, Pt, Mo, W, and HfO₂.

11. A preparation method for an acoustic resonator, comprising:
providing a substrate layer, and forming a piezoelectric transducer structure layer on one side of the substrate layer; and
forming an energy adjustment layer between the substrate layer and the piezoelectric transducer structure layer, wherein the energy adjustment layer comprises a plurality of confinement grooves, and each confinement groove passes through at least a surface that is of the energy adjustment layer and that faces the piezoelectric transducer structure layer.

12. A filter, comprising a plurality of cascaded resonators, wherein the resonator is the acoustic resonator according to any one of claims 1 to 10.

13. An electronic device, comprising a filter and a circuit board, wherein the filter is disposed on the circuit board, and the filter is the filter according to claim 12.
